# DEMANDE DE BREVET EUROPEEN

(11) **EP 0 803 917 A1**
(43) Date de publication de la demande: **29.10.1997**
(21) Numéro de dépôt: 97400863.3
(22) Date de dépôt: 17.04.1997
(51) Int. Cl.: H01L 39/14, H01L 39/24

(54) **Brin supraconducteur multifilamentaire htc et un procédé de fabrication d'un tel brin**

(30) Priorité: 22.04.1996 FR 9605013
(71) Demandeur: ALCATEL ALSTHOM COMPAGNIE GENERALE D'ELECTRICITE, 75382 Paris Cédex 08 (FR)
(72) Inventeur: Herrmann, Peter Friedrich, 91410 Corbreuse (FR); Beghin, Erick, 92100 Boulogne sur Seine (FR); Duperray, Gérard, 91290 La Norville (FR); Legat, Denis, 91090 Lisses (FR)
(74) Mandataire: Fournier, Michel

(57) **Abrégé**

L'invention concerne un brin multifilamentaire supraconducteur HTc comprenant une pluralité de filaments supraconducteur (2), chaque filament supraconducteur (2) comprenant un coeur en céramique HTc (3), ledit coeur en céramique HTc (3) étant entouré par une gaine d'Ag (4), elle-même entourée par un alliage résistif (5),

selon l'invention chaque filament comprend une couche intermédiaire d'oxyde isolant (6) localisée entre la gaine d'Ag (4) et l'alliage résistif (5).

## Description

L'invention concerne un brin supraconducteur multifilamentaire à Haute Température critique (HTc) et un procédé de fabrication d'un tel brin. Plus particulièrement l'invention concerne un brin supraconducteur HTc multifilamentaire à gainage d'Argent utilisé en courant alternatif, et un procédé de fabrication d'un tel brin.

L'utilisation en courant alternatif des brins supraconducteurs multifilamentaires HTc implique un bon découplage des filaments supraconducteurs HTc constitutifs afin de limiter les pertes énergétiques par les courants induits.

Il est connu de réaliser des brins multifilamentaires HTc par la technologie "Poudre En Tube" (Powder In Tube). Cela consiste à remplir une billette de réactifs poudreux susceptibles, après traitement thermique, de se transformer en matériau supraconducteur notamment du type céramique HTc.

Cette billette est ensuite fermée sous vide et étirée, mise en faisceau dans une nouvelle billette elle-même fermée sous vide et étirée à son tour.

Le brin ainsi réalisé est alors mis en forme définitive par exemple par laminage, puis traité thermiquement pour la transformation des réactifs poudreux.

On sait que le matériau constitutif des billettes doit être suffisamment ductile pour pouvoir subir les différentes phases d'étirages et de laminage, et avoir une composition inerte ou du moins sans conséquences pour le traitement thermique de transformation des réactifs poudreux en phase supraconductrice. Il est connu d'utiliser l'Argent comme matériau constitutif des billettes.

Cependant, l'Argent est un matériau très conducteur aux températures de fonctionnementdes supraconducteurs HTc. De ce fait le découplage électrique entre filament est quasiment inexistant.

Il est connu de doper l'Ag avec des impuretés du type Pd ou Au à 1 ou 2 %. Cette technique permet de gagner 2 décades de résistivité à 20 K.

Cette technique permet des applications à 77 K. Cependant l'alliage Ag/Pd est coûteux ce qui le rend économiquement rédhibitoire dans des applications de grande série.

L'un des buts de la présente invention est de proposer un brin multifilamentaire dont le découplage des filaments est sensiblement amélioré.

Un autre but de la présente invention est de proposer un brin multifilamentaire et un procédé de fabrication sensiblement moins coûteux que l'utilisation d'Argent dopé pour un découplage supérieur.

A cet effet l'invention concerne un brin multifilamentaire supraconducteur HTc comprenant une pluralité de filaments supraconducteurs, chaque filament supraconducteur comprenant un coeur en céramique supraconductrice HTc, ledit coeur en céramique supraconductrice HTc étant entouré par une gaine d'Ag, elle-même entourée par un alliage résistif.

Selon l'invention, chaque filament supraconducteur comprend une couche intermédiaire d'oxyde isolant localisée entre la gaine d'Ag et l'alliage résistif.

Le brin comprend en outre une gaine d'alliage résistif entourant les filaments constitutifs.

La couche intermédiaire d'oxyde isolant peut comprendre des trous à travers lesquels l'alliage résistif du filament est au contact de la gaine d'Ag.

Dans un mode de réalisation l'alliage résistif est du cupro-aluminium, et la couche intermédiaire d'oxyde est de l'Alumine.

L'invention concerne aussi un procédé de fabrication du type "poudre en tube" d'un brin multifilamentaire supraconducteur HTc selon lequel
on remplit une première billette de réactifs poudreux susceptibles après traitement thermique de se transformer en matériau supraconducteur HTc;
on ferme sous vide et on étire la première billette en un brin;
on réalise au moins une fois une étape selon laquelle
on met le brin en faisceau dans une billette secondaire, la billette secondaire étant fermée sous vide et étirée à son tour en un nouveau brin;
on met en forme le nouveau brin; et
on effectue un traitement thermiquement du brin mis en forme pour transformer les réactifs poudreux en matériaux supraconducteur HTc.

Selon l'invention :
on réalise des billettes composites multicouches comprenant au moins une épaisseur extérieure d'alliage métallique dont un au moins des composants est oxydable et une épaisseur intérieure d'Argent; et
on effectue un traitement thermique de sorte que les composants oxydables de l'alliage métallique diffusent à l'interface alliage métallique/argent et, en présence d'oxygène ou de composés oxygénés, s'oxydent en formant un oxyde isolant à ladite interface.

Selon une mise en oeuvre du procédé, le traitement thermique de diffusion est réalisé en même temps que le traitement thermique de transformation de la poudre en supraconducteur HTc.

Selon une autre mise en oeuvre du procédé, l'étape de mise en forme du brin est en aval du traitement thermique de diffusion et en amont du traitement thermique de transformation. Dans cette mise en oeuvre, la couche d'oxyde peut être déchirée par endroits lors de la mise en forme, de telle manière que l'alliage résistif soit au contact de la gaine d'Ag à travers lesdites déchirure.

Dans un mode de mise en oeuvre du procédé, l'alliage métallique est du cupro-aluminium à 4%, une partie de l'aluminium diffusant à l'interface alliage métallique/argent et s'oxydant en Alumine lors du traitement thermique.

Un premier avantage de la présente invention résulte des meilleurs caractéristiques isolantes des oxydes isolants par rapport à l'Argent dopé.

Un autre avantage de la présente invention résulte de la réduction des coûts de fabrication d'un brin selon l'invention.

Un autre avantage de la présente invention résulte du fait que le procédé proposé par l'invention peut être mis en oeuvre sur les dispositifs de fabrication existants.

D'autres avantages et caractéristiques de la présente invention résulteront de la description qui va suivre en référence aux dessins annexés dans lesquels :

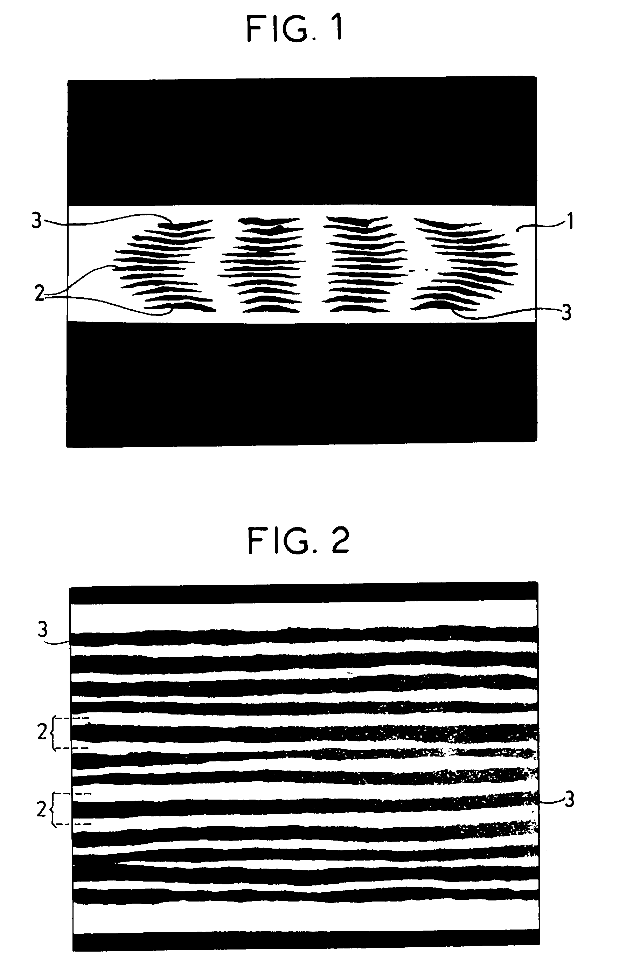

la figure 1 montre un brin multifilamentaire selon l'invention en coupe transversale.

La figure 2 montre un brin multifilamentaire selon l'invention en coupe longitudinale.

La figure 3 montre un détail de la structure d'un filament du brin multifilamentaire selon l'invention. La figure 4 montre un agrandissement d'une partie IV du détail représenté sur la figure 3.

L'invention concerne un brin multifilamentaire supraconducteur HTc 1 comprenant une pluralité de filaments supraconducteurs 2 , chaque filament supraconducteur comprenant un coeur en céramique supraconductrice HTc 3 entouré par une gaine d'Ag 4, elle-même entourée par un alliage résistif 5.

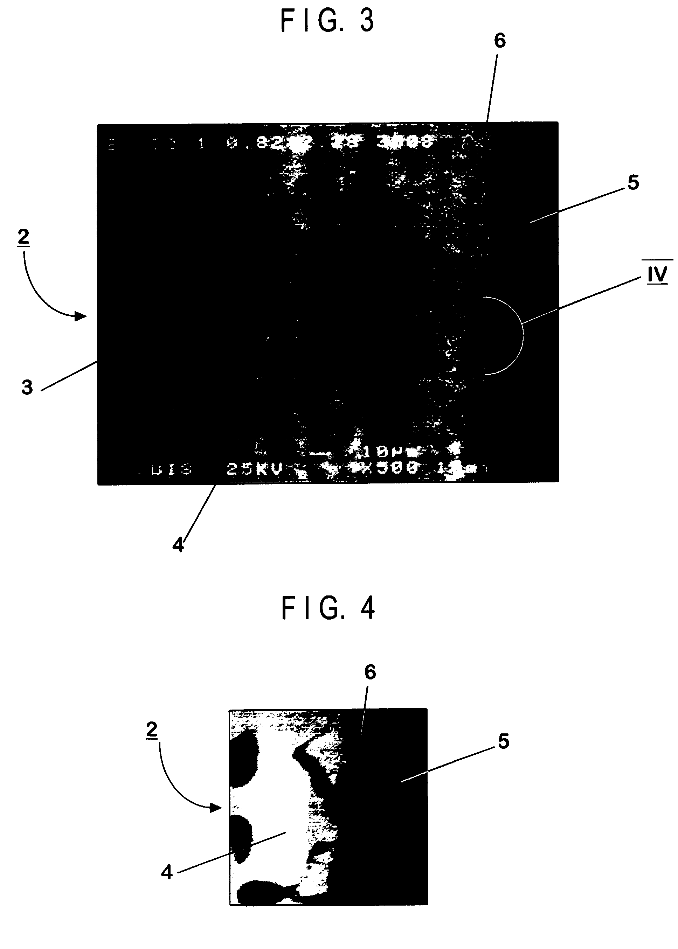

Selon l'invention chaque filament supraconducteur 2 comprend une couche intermédiaire d'oxyde isolant 6 localisée entre la gaine d'Ag 4 et l'alliage résistif 5 (FIG. 3 et 4).

Les filaments constitutifs du brin sont contenus dans une gaine d'alliage résistif.

La couche intermédiaire d'oxyde isolant 6 peut comprendre des trous non représentés à travers lesquels l'alliage résistif est au contact de la gaine d'Ag.

Dans un mode de réalisation l'alliage résistif est du cupro-aluminium, et la couche intermédiaire d'oxyde est de l'alumine (Al₂O₃) .

L'invention concerne aussi un procédé de fabrication du type "poudre en tube" d'un brin multifilamentaire supraconducteur HTc selon lequel
on remplit une première billette de réactifs poudreux susceptibles après traitement thermique de se transformer en matériau supraconducteur HTc et on ferme la billette sous vide;
on étire la première billette en un brin;
on réalise au moins une fois, une étape selon laquelle
on met le brin en faisceau dans une billette secondaire, on ferme la billette secondaire sous vide, et on étire la billette secondaire à son tour en un nouveau brin;
on réalise une mise en forme du nouveau brin;
on effectue un traitement thermiquement du brin mis en forme pour transformer les réactifs poudreux en matériaux supraconducteur HTc;
selon l'invention :
on réalise des billettes composites bi-couches comprenant une épaisseur extérieure d'alliage métallique dont un au moins des composants est oxydable et une épaisseur intérieure d'Argent; et
on effectue un traitement thermique de sorte que les composants oxydables de l'alliage métallique diffusent à l'interface alliage métallique/argent et, en présence d'oxygène ou de composés oxygénés, s'oxydent en formant un oxyde isolant à ladite interface.

Selon une mise en oeuvre du procédé, le traitement thermique de diffusion est réalisé en même temps que le traitement thermique de transformation de la poudre en supraconducteur HTc.

Selon une autre mise en oeuvre du procédé, l'étape de mise en forme du brin est en aval du traitement thermique de diffusion et en amont du traitement thermique de transformation. Dans cette mise en oeuvre, la couche d'oxyde peut être déchirée par endroits lors de la mise en forme, de telle manière que l'alliage résistif soit au contact de la gaine d'Ag à travers lesdites déchirure.

Dans un mode de mise en oeuvre du procédé, l'alliage métallique est du cupro-aluminium à 4%, une partie de l'aluminium diffusant à l'interface alliage métallique/argent et s'oxydant en Alumine lors du traitement thermique.

La gaine extérieure du brin, c'est à dire la dernière billette peut être uniquement en alliage résistif sans Ag.

Dans une variante économique, seule la première billette est une billette composite en Ag et en matériau résistif oxydable.

Bien entendu, l'invention n'est pas limitée aux modes de réalisation décrits et représentés, mais elle est susceptible de nombreuses variantes accessibles à l'homme du métier sans que l'on s'écarte de l'invention. En particulier, on pourra, sans sortir du cadre de l'invention, remplacer le cupro-aluminium par tout alliage métallique oxydable équivalent. De même la gaine d'Ag pourrait être remplacée par une gaine d'alliage à base d'Ag sans que l'on sorte de la présente invention.

## Revendications

1. Brin multifilamentaire supraconducteur HTc comprenant une pluralité de filaments supraconducteurs HTc, chaque filament supraconducteur HTc comprenant un coeur en céramique supraconductrice HTc, ledit coeur en céramique supraconductrice HTc étant entouré par une gaine d'Ag, elle-même entourée par un alliage résistif caractérisé en ce que chaque filament supraconducteur HTc comprend une couche intermédiaire d'oxyde isolant localisée entre la gaine d'Ag et l'alliage résistif.

2. Brin multifilamentaire supraconducteur HTc selon la revendication 1 caractérisé en ce que les filaments supraconducteurs HTc constitutifs du brin sont contenus dans une gaine d'alliage résistif.

3. Brin multifilamentaire HTc selon la revendication 1 ou 2 caractérisé en ce que les couches intermédiaires d'oxyde isolant des filements supraconducteurs HTc comprennent des trous à travers lesquels l'alliage résistif est au contact de la gaine d'Ag.

4. Brin multifilamentaire selon l'une quelconque des revendications 1 à 3 caractérisé en ce que l'alliage résistif est du cupro-aluminium, et les couches intermédiaires d'oxyde sont en Alumine.

5. Procédé de fabrication d'un brin multifilamentaire HTc du type "poudre en tube" selon lequel
on remplit une première billette de réactifs poudreux susceptibles après traitement thermique de se transformer en matériau supraconducteur HTc;
on étire la première billette en un brin; brin;
on réalise au moins une fois une étape selon laquelle
on met le brin en faisceau dans une billette secondaire, la billette secondaire étant étirée à son tour en un nouveau brin;
on réalise une mise en forme du nouveau brin;
on effectue un traitement thermiquement du brin mis en forme;
le procédé est caractérisé en ce que
on réalise au moins une billette composite multicouche comprenant au moins une épaisseur extérieure d'alliage métallique dont un au moins des composants est oxydable et une épaisseur intérieure d'Argent;
; et
on effectue un traitement thermique de sorte que les composants oxydables de l'alliage métallique diffusent à l'interface alliage métallique/argent et, en présence d'oxygène ou de composés oxygénés, s'oxydent en formant un oxyde isolant à ladite interface.

6. Procédé selon la revendication 5 caractérisé en ce que le traitement thermique de diffusion est réalisé en même temps que le traitement thermique de transformation des réactifs poudreux en supraconducteur HTc.

7. Procédé selon la revendication 5 caractérisé en ce que l'étape de mise en forme du brin est en aval du traitement thermique de diffusion et en amont du traitement thermique de transformation.

8. Procédé selon la revendication 7 caractérisé en ce que lors de l'étape de mise en forme la couche d'oxyde de certains filaments est déchirée par endroits, de telle manière que l'alliage résistif soit au contact de la gaine d'Ag à travers lesdites déchirure.

9. Procédé selon l'une quelconque des revendications 5 à 8 caractérisé en ce que l'alliage métallique est du cupro-aluminium à 4%, une partie de l'aluminium diffusant à l'interface alliage métallique/argent et s'oxydant en alumine lors du traitement thermique.

10. Procédé selon l'une quelconque des revendications 5 à 9 caractérisé en ce que seule la première billette est une billette composite, la ou les billettes secondaires étant en matériau résistif.
